# EUROPEAN PATENT SPECIFICATION

(11) **EP 3 886 145 B1**
(45) Date of publication and mention of the grant of the patent: **28.10.2026**
(21) Application number: 20165087.6
(22) Date of filing: 24.03.2020
(51) Int. Cl.: B82Y 10/00, H10D 30/01, H10D 30/43, H10D 62/10, H10D 84/01, H10D 84/03

(54) **METHOD FOR PROCESSING A NANOSHEET DEVICE**
VERFAHREN ZUR VERARBEITUNG EINER NANOSHEET-VORRICHTUNG
PROCÉDÉ DE TRAITEMENT D'UN DISPOSITIF NANOSHEET

(43) Date of publication of application: 29.09.2021
(73) Proprietor: Imec VZW, 3001 Leuven (BE)
(72) Inventor: CHAN, Boon Teik, 3001 Leuven (BE); XIAO, Changyong, 3001 Leuven (BE); CHEN, Jie, 3001 Leuven (BE)
(74) Representative: Roth, Sebastian

(56) References cited:
- US-A1- 2011 045 648
- US-A1- 2018 211 866
- US-A1- 2019 074 224
- US-A1- 2020 020 540
- WECKX P ET AL: "Novel forksheet device architecture as ultimate logic scaling device towards 2nm", 2019 IEEE INTERNATIONAL ELECTRON DEVICES MEETING (IEDM), IEEE, 7 December 2019 (2019-12-07), XP033714586, DOI: 10.1109/IEDM19573.2019.8993635
- TAO Z ET AL: "FEOL dry etch process challenges of ultimate FinFET scaling and next generation device architectures beyond N3", ADVANCES IN RESIST TECHNOLOGY AND PROCESSING XVI, S P I E - INTERNATIONAL SOCIETY FOR OPTICAL ENGINEERING, US, vol. 11329, 23 March 2020 (2020-03-23), pages 113290O - 113290O, XP060131975, ISSN: 0277-786X, DOI: 10.1117/12.2552022
- WECKX P. ET AL: "Novel forksheet device architecture as ultimate logic scaling device towards 2nm", 2019 IEEE INTERNATIONAL ELECTRON DEVICES MEETING (IEDM), 1 December 2019 (2019-12-01), pages 36.5.1 - 36.5.4, XP093368498, ISBN: 978-1-72814-032-2, DOI: 10.1109/IEDM19573.2019.8993635

## Description

### TECHNICAL FIELD OF THE INVENTION

The present disclosure relates to a method for processing a Forksheet device and further relates to a Forksheet device obtainable by said method.

### BACKGROUND OF THE INVENTION

A fin field-effect transistor (FinFET) is a type of metal-oxide semiconductor field effect transistor (MOSFET) with a fin shaped channel between the source and drain terminals. Thereby, the gate is placed on two or three sides of the fin shaped channel, and preferably surrounds the channel. Compared to a conventional planar MOSFET, such as a CMOS, a FinFET allows for faster switching times and higher current densities.

A Forksheet (FSH) device may be considered to be a special type of FinFET, where the fin shaped channel comprises a plurality of vertically stacked nanosheets. The fin shaped channel of a Forksheet device further comprises a pMOS and an nMOS side, which are separated by a dielectric isolation in the center of the fin. By using such a Forksheet design, the switching times of a FinFET device can be increased, while a power consumption of the device can be reduced.

However, it is difficult to fabricate FinFETs and Forksheet devices. In particular, current fabrication processes do not allow controlling critical dimensions such as the height of the fin structure and the height of the dielectric isolation within the fin structure independently. This leads to strong limitations in the FinFET and Forksheet designs.

US 2019074224 A1 discloses gate all-around integrated circuit structures and FinFETs having a dielectric isolation.

US 2020020540 A1 discloses techniques for tight pitch patterning of fins using a cyclic selective deposition process.

WECKX P ET AL, "Novel forksheet device architecture as ultimate logic scaling device towards 2nm", 2019 IEEE INTERNATIONAL ELECTRON DEVICES MEETING (IEDM), IEEE, December 7 2019, discloses a forksheet device architecture achieving extremely scaled PMOS to NMOS separation using limited additional processing complexity. The disclosed manufacturing process for the forksheet device involves simultaneously structuring a stack of nanosheets into fin structures, that are arranged in pairs separated by trenches. The trenches are filled with a dielectric material and p-type and n-type epitaxial source/drain regions are grown on either side of the trenches.

AO Z ET AL, "FEOL dry etch process challenges of ultimate FinFET scaling and next generation device architectures beyond N3", ADVANCES IN RESIST TECHNOLOGY AND PROCESSING XVI, S P I E - INTERNATIONAL SOCIETY FOR OPTICAL ENGINEERING, US, March 23 2020, discloses FEOL dry etch process challenges of ultimate FinFET scaling and next generation device architectures.

US 8039326 B2 discloses methods for fabricating Bulk FinFET devices having deep trench isolation.

US 2018211866 A1 discloses a method for forming a semiconductor structure including forming a plurality of fins over a substrate.

### SUMMARY OF THE INVENTION

Thus, it is an objective to provide an improved method for processing a Forksheet device and to provide an improved Forksheet device obtainable by said method. In particular, the above-mentioned disadvantages should be avoided.

The objective is achieved by the solution provided in the enclosed independent claims. Advantageous implementations of the present invention are further defined in the dependent claims.

According to a first aspect, the present disclosure relates to method for processing a Forksheet device, wherein the method comprises:
- providing a substrate, wherein the substrate comprises a nanosheet structure of alternating nanolayers of two different semiconductor materials;
- forming a trench in the substrate, wherein the trench extends along a first direction, and wherein the trench passes through the nanosheet structure;
- filling the trench with a filling material;
- partially recessing the substrate to form a fin structure, wherein the fin structure comprises the filled trench, a first section of the substrate at a first side of the filled trench and a second section of the substrate at a second side the filled trench, wherein the first and the second section of the substrate form opposite sides of the fin structure and each comprise a part of the nanosheet structure, and wherein the filled trench forms a dielectric isolation barrier of the fin structure;
- forming a p-doped region on or in the first section of the substrate and forming an n-doped region on or in the second section of the substrate, wherein the p-doped and the n-doped regions are formed by means of an epitaxy growth process, during an epitaxial formation of source and drain terminals; and
- forming a gate structure on and around the fin structure;

where the step of forming the trench in the substrate comprises:
   - forming a grating structure on the substrate, wherein the grating structure comprises a pair of maskings extending along the first direction, wherein the pair of maskings are arranged at a distance from each other; and
   - etching into the substrate in a region between the pair of maskings to form the trench; and
where a spacer layer is formed at least partially around the pair of maskings, in particular on facing sidewalls of each of the pair of maskings

This achieves the advantage that the Forksheet device can be processed efficiently and with high process control.

In particular, by forming the trench and recessing the substrate in two separate and decoupled process steps, the depth of the trench and the height of the fin structure, which comprises the trench, can be controlled independently from another. In contrast, forming the trench and the fin structure simultaneously would make the trench depth dependent on the fin height.

In addition, by forming the trench and recessing the substrate in two separate and decoupled process steps, effects such as micro-loading and intra-cell fin loading, i.e. local variations in the etch rate, can be decreased. These local variations are caused, for instance, by a difference between a trench width and a fin-to-fin distance when forming trench and fin structure simultaneously. By eliminating these effects, straighter wall profiles of the trench and better critical dimension control of the fin structure and trench can be achieved.

Filling the trench prior to forming the fin structure provides the additional advantage that the inner walls of the trench are protected by the filling material when forming the fin structure.

Notably, the trench can be formed efficiently with high precision. In particular, the spacer layer enhances a critical dimension (CD) control of the trench, e.g. the diameter of the trench formed in the substrate between the maskings can be further reduced by applying the spacer layer to the facing sidewalls of the maskings. Preferably, the facing sidewalls refer to the inner sidewalls of the maskings on the side of each masking where the trench is formed.

The Forksheet device can be a nanosheet device, in particular a nanosheet FET, in particular a Forksheet FET (FSH FET).

Further, the Forksheet device may be referred to as a FinFet device.

The fin structure can form a channel of the Forksheet device. Preferably, the fin structure is arranged between a source and a drain terminal of the Forksheet device.

Alternatively, the n-doped region can be formed on or in the first section and/or the p-doped region can be formed on or in the second section.

Preferably, the fin structure forms a channel, wherein the first section defines a p-gate contact and the second section defines an n-gate contact of the channel, or vice versa. In particular, the Forksheet device is a multigate device, wherein the gate structure of the Forksheet device comprises a p-gate and an n-gate.

Forming the p-doped and the n-doped regions are by means of an epitaxy growth process, during an epitaxial formation of source and drain terminals achieves the advantage that the first and second section can be doped efficiently, during source and drain formation.

For example, the p-doped region can be formed by deposing SiGe:B (SiGe with Boron doping) and Ga, and the n-doped region can be formed by deposing SiP (silicon with phosphor doping) and As, preferably on the first respectively second section of the fin structure.

In particular, the grating structure comprises a hard mask on the substrate.

The etching between the pair of maskings can comprise a wet etching process and/or a dry etching process, such as a reactive ion etching process.

In an embodiment, the step of forming the trench in the substrate further comprises:
- forming, following the forming of the grating structure, a sacrificial structure on the substrate and on and around the grating structure, wherein the sacrificial structure comprises at least one material layer; and
- selectively removing the sacrificial structure in a region between the pair of maskings.

This achieves the advantage that the trench can be formed efficiently with high precision.

In an embodiment, the fin structure is formed by recessing, in particular etching, the substrate at a distance from each side of the filled trench.

This achieves the advantage that the fin structure can be formed efficiently. The etching can comprise a wet or a dry etching process.

In an embodiment, the distance from each side of the filled trench is defined by a width of the masking on the respective side of the trench.

This achieves the advantage that the fin structure can be formed efficiently with high precision.

Preferably, the fin structure is fully self-aligned to the maskings, which can form a hardmask grating. The maskings can enable a critical dimension (CD) control of the fin structure.

In an embodiment, a difference between a depth of the trench and a height of the fin structure is less than 10%, in particular less than 5%, more particular less than 2%, or wherein the depth of the trench essentially corresponds to the height of the fin structure.

This achieves the advantage that the Forksheet device can be processed with high process control over the design parameters. In particular, by forming the trench and recessing the substrate in two separate and decoupled process steps, the depth of the trench and the height of the fin structure can be tuned independently, for instance to be essentially identical.

In an embodiment, the depth of the trench is larger than or equal to the height of the fin structure.

This achieves the advantage that the Forksheet device can be processed with high process control over the design parameters. In particular, local variations in the etch rate that would occur when forming the trench and the fin structure simultaneously, can be prevented. These local variations would, for instance, be caused by a difference between a trench-width to a fin-to-fin distance and would typically lead to the trench depth being smaller than the fin structure height.

In another embodiment, the depth of the trench is smaller than the height of the fin structure. Preferably, the trench depth and the fin height can be controlled independently from another.

In an embodiment, the filling material comprises a dielectric material, in particular silicon nitride (SiN), silicon carbide (SiC), silicon oxycarbonitride (SiOCN), silicon carbonitride (SiCN), silicon dioxide (SiO2), silicon carbon oxide (SiCO), or silicon oxynitride (SiON).

Preferably, the filled trench forms a dielectric isolation barrier of the fin structure.

In an embodiment, the trench is filled by means of a plasma-enhanced atomic layer deposition, PEALD, process.

This achieves the advantage that the trenched can be filled efficiently with high process control.

Alternatively, the trench can be filed by a low temperature (LT) SiN deposition and/or a flowable chemical vapor deposition (FCVD) of SiC.

The two different semiconductor materials may be Si and SiGe.

A nanosheet structure of alternating nanolayers of two different semiconductor materials achieves the advantage that a fin structure that comprises the alternating nanolayers, such as a Forksheet structure, can be processed efficiently. In particular, when partially recessing the substrate to form the fin structure, the first and second section of the substrate, which form opposite sides of the fin structure, each comprise the nanosheet structure.

According to a second aspect, the present disclosure relates to a Forksheet device obtainable by the method according to first aspect of the invention, in particular wherein a difference between a depth of the trench and a height of the fin structure is less than 10%, in particular less than 5%, more particular less than 2%, or wherein the depth of the trench essentially corresponds to the height of the fin structure.

This achieves the advantage that a Forksheet device can be provided, which is processed efficiently and with high process control.

Such a Forksheet device produced with the method of the first aspect shows clear "fingerprints" of that method. By forming the trench and recessing the substrate in two separate and decoupled process steps, the depth of the trench and the height of the fin structure, which comprises the trench, can be controlled independently from another; in particular, the trench depth can be larger or essentially identical to the fin height. In contrast, forming the trench and the fin structure simultaneously in a joint process step, e.g. an etching step, would make the trench depth dependent on the fin height, wherein typically the trench depth would be less than the fin height, e.g. due to so called micro-loading effects.

### BRIEF DESCRIPTION OF THE DRAWINGS

The invention will be explained in the followings together with the figures.
- Figs. 1a-i: shows steps of a method for processing a Forksheet device according to an embodiment of the invention; and

- Figs. 2a-j: shows steps of a method for processing a Forksheet device according to an embodiment of the invention.

### DETAILED DESCRIPTION OF THE PREFERRED EMBODIMENTS

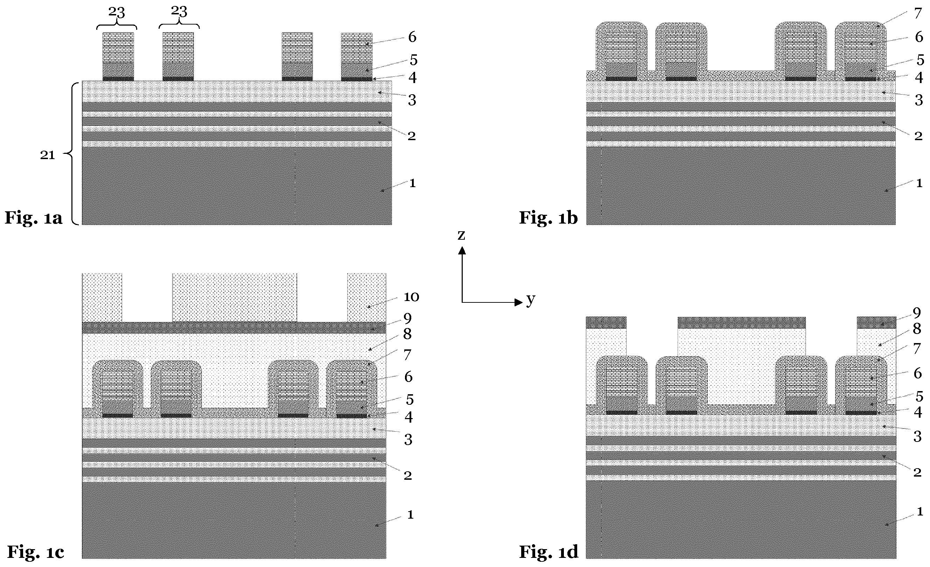

Figs. 1a-i shows steps of a method for processing a Forksheet device according to an embodiment. In particular, the main steps for forming the fin structure of a Forksheet device are illustrated.

The method comprises, as shown in FIG. 1a, providing a substrate 21.

The substrate 21 can comprise a base structure 1, e.g. composed of Si, and a nanosheet structure of alternating nanolayers 2, 3 arranged on the base structure 1. The alternating nanolayers can comprise Si layers 2 and SiGe layers 3. For example, the Si layers 2 have a thickness of 10 nm and the SiGe layers 3 have a thickness of 7 nm when arranged between two Si layers 2. The upper SiGe layer 3 can form a top layer of the substrate 21 and can have a larger thickness of e.g. 30 nm. The SiGe layers 3 can comprise 30% Germanium (Ge).

The method further comprises, as shown in FIG. 1a, forming a grating structure on the substrate 21, wherein the grating structure comprises a pair of maskings 23 extending along a first direction, here along the x-direction. The pair of maskings 23 are arranged at a first distance from each other. The x-direction is perpendicular to the z-direction, wherein the z-direction is in-line with the direction of layer fabrication, and the x-direction is also perpendicular to the y-direction, as indicated by the schematic coordinate system. The x-direction extends into the plane of Figs. 1a-i.

In the exemplary embodiment of Fig. 1a, two pairs of maskings 23 on the substrate 21 are shown, wherein each of the pair of maskings 23 defines where a fin structure will be formed. For the sake of clarity, in the following the method is explained with reference to one of the pairs of maskings 23 and the fin structure generated by means of this pair of maskings 23, obviously the same applies to the second pair.

Preferably, each of the pair of maskings 23 comprises a bottom layer 4, a mid-layer 5 and a top layer 6. The bottom layer 4 can be made of SiO₂, the mid layer 5 can be made of Si₃N₄ (silicon nitride), and the top layer 6 can be made of SiC, SiCO or SiO2.

In particular, the grating structure forms a hardmask (HM) on the substrate 21. The grating structure can be formed by a deposition of the layer 4, 5, 6 materials on the substrate 21 followed by a photolithographic structuring of said layers 4, 5, 6.

As shown in Fig. 1b, the method further comprises forming a spacer layer 7 on the substrate 21 and around the pair of maskings 23, in particular the spacer layer 7 is also formed on facing sidewalls of the pair of maskings 23.

The spacer layer can be formed by a deposition process, such as plasma enhanced atomic layer deposition (PEALD), and can comprise Si₃N₄ and/or SiO2.

As shown in Fig. 1c, the method further comprises forming a sacrificial structure on the substrate 21 and on and around the grating structure. The sacrificial structure comprises at least one material layer 8, 9, 10.

In Fig 1c, the sacrificial structure comprises three material layers 8, 9, 10, namely a spin-on carbon (SoC) layer 8, a spin-on glass (SoG) layer 9 and a photoresist (PR) layer 10. The PR layer 10 can be opened in regions above the pair of maskings 23, in particular by means of selective illumination of the PR layer 10 through a photolithographic mask, followed by development and removal steps.

As shown in Fig. 1d, the method further comprises a selective removal, i.e. opening, of the sacrificial structure, in particular of the SoC and SoG layers 8, 9 in a region between the pair of maskings 23.

The selective removal can be achieved by etching the SoC and SoG layers 8, 9 below the openings of the PR layer 8. In particular, the SoC and SoG layers 8, 9 are etched by a dry etching step, that selectively removes the SoC and SoG material but leaves the PR layer 9 mostly intact.

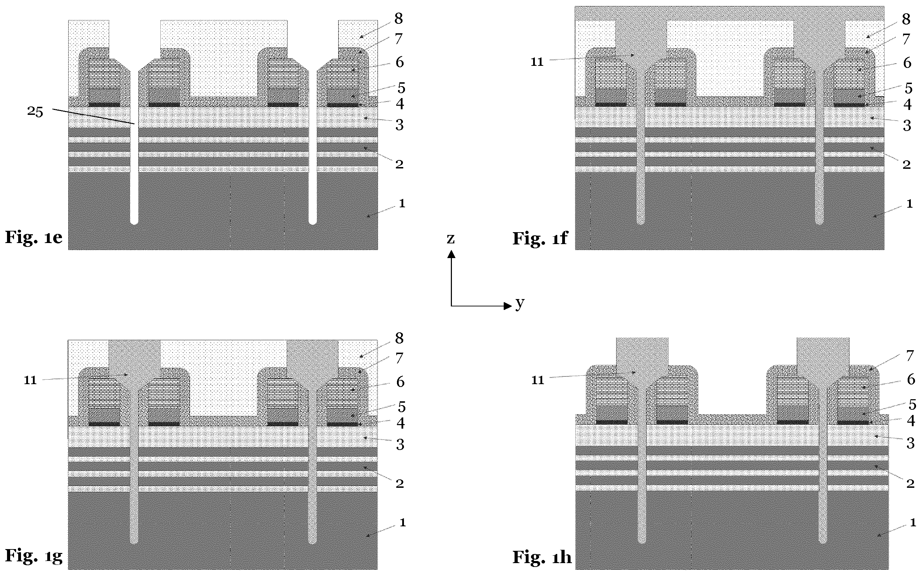

As shown in Fig. 1e, the method further comprises forming a trench 25 in the substrate 21, wherein the trench extends along the x-direction.

The trench 25 can be formed by etching into the substrate 21 in a region between the pair of maskings 23, e.g. by an isotropic etching process such as reactive ion etching. For example, the trench 25 has a width of 8 nm.

As shown in Fig. 1f, the method further comprises filling the trench 25 with a filling material 11.

The filling material 11 can be a dielectric material that will form a dielectric isolation barrier of the fin structure.

The trench 25 can be filled by means of a plasma-enhanced atomic layer deposition, PEALD, process. Alternatively, the trench 25 can be filed by a low temperature (LT) SiN deposition and/or a flowable chemical vapor deposition (FCVD) of SiC.

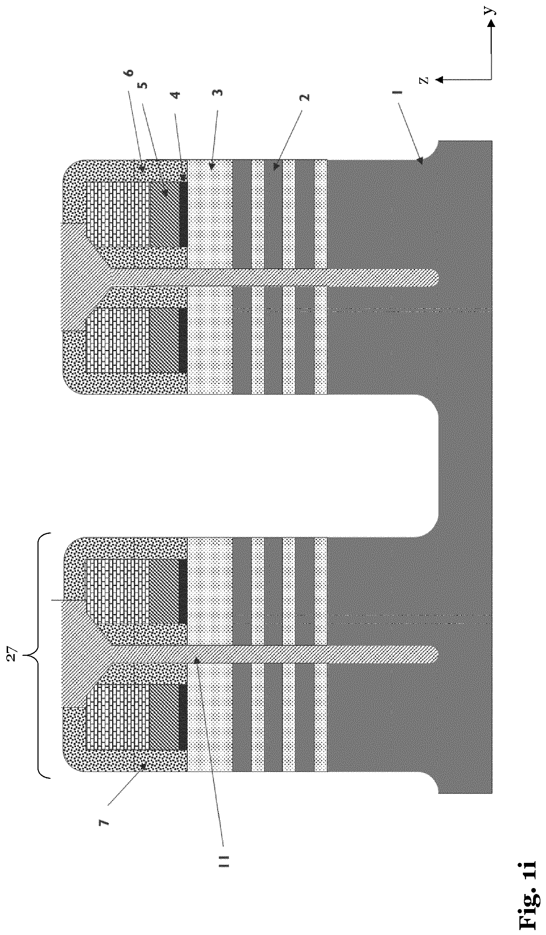

Filling the trench 25 prior to forming the fin structure (c.f. Fig. 1i) provides the additional advantage that the inner walls of the trench 25 are protected by the filling material 11 when recessing the substrate to form the fin structure.

As shown in Fig. 1g, the method further comprises recessing the trench filling material. The filling material can be recessed by an etch back or by a chemical-mechanical polishing (CMP).

Preferably, the method further comprises a removal of the remnants of the sacrificial structure, as shown in FIG. 1h. In particular, the removal of the sacrificial structure comprises a stripping of the SoC layer. 8

As shown in Fig. 1i, the method comprises partially recessing the substrate 21 to form a fin structure 27.

The fin structure 27 can comprise the filled trench 25, a first section of the substrate at a first side of the filled trench 25 and a second section of the substrate at a second side of the filled trench 25.

The fin structure 27 can be formed by recessing the substrate at a distance from each side of the filled trench 25, in particular the distance at each side is defined by a width of the respective masking 23 of the pair of maskings 23 and preferably of the thickness of the spacer layer 7 around the maskings 23. The fin structure can be self-aligned to the maskings 23, which can form a hardmask grating. The masking can enhance a critical dimension (CD) control of the fin structure 25.

In particular, recessing the substrate to form the fin structure 2 can be realized by means of a suitable dry or a wet etching process, in particular by means of an isotropic etch-back process. During or after said recess, excess filling material 11 that protrudes from the pair of maskings 23 can be removed.

Forming and filling the trench 25 prior to forming the fin structure 27 makes it possible to control the design of the trench 25, in particular its depth, independently from the height of the fin structure 27. For instance, the difference between the depth of the trench 25 and the height of the fin structure 27 can be set to be less than 10%, 5%, 2%, or even 1%. In particular, the respective process steps can be tuned in such a way that the height of the fin structure 27 after recess essentially corresponds to the depth of the trench 25. The depth of the trench 25 can also be set to be larger than the height of the fin structure 27 such that the filled trench below the fin structure 27 extends further into the substrate 21. In contrast, when the trench 25 and the fin structure 27 would be formed simultaneously, the trench 25 depth would typically be less than the fin height, in particular due to local variations in the etch rate. These local variations would, for instance, be caused by a difference between a trench width to a fin-to-fin distance. This limitation can be overcome by forming trench and fin structure in separate steps.

Following formation of the fin structure 27, a p-doped region can be formed on the fin, in particular on or in the first section of the substrate 21. Likewise, an n-doped region can be formed on the fin, in particular on or in the second section of the substrate 21.

The p-doped and/or the n-doped regions can be formed by means of an epitaxy growth process, preferably during an epitaxial formation of source and drain terminals. For example, the p-doped region can be formed by deposing SiGe:B (SiGe with Boron doping) and Ga, and the n-doped region can be formed by deposing SiP (silicon with phosphor doping) and As.

Preferably, in a further step the method comprises forming a gate structure on and around the fin structure 27.

The gate structure can comprise a p-gate in contact with a p-doped region of the fin structure 27 and an n-gate in contact with an n-doped region of the fin structure 27.

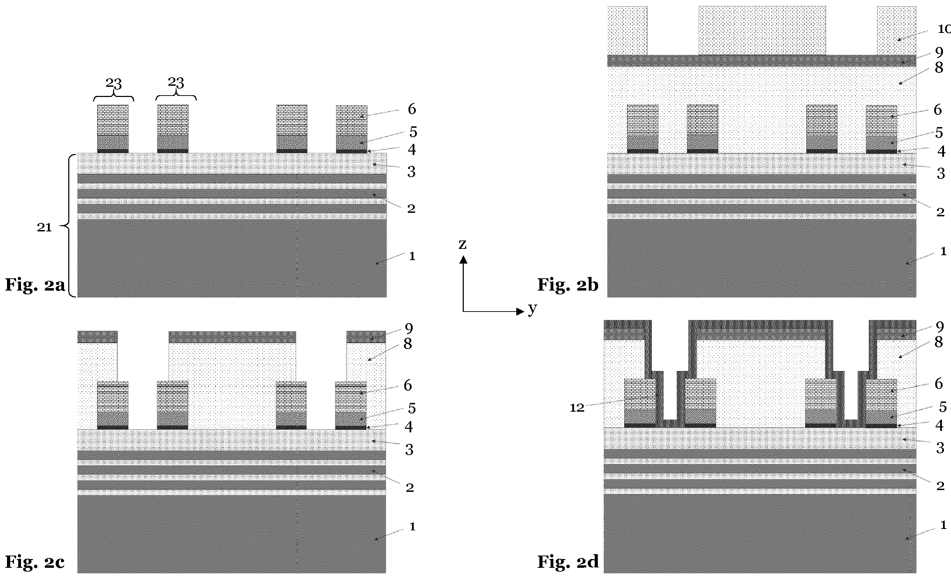

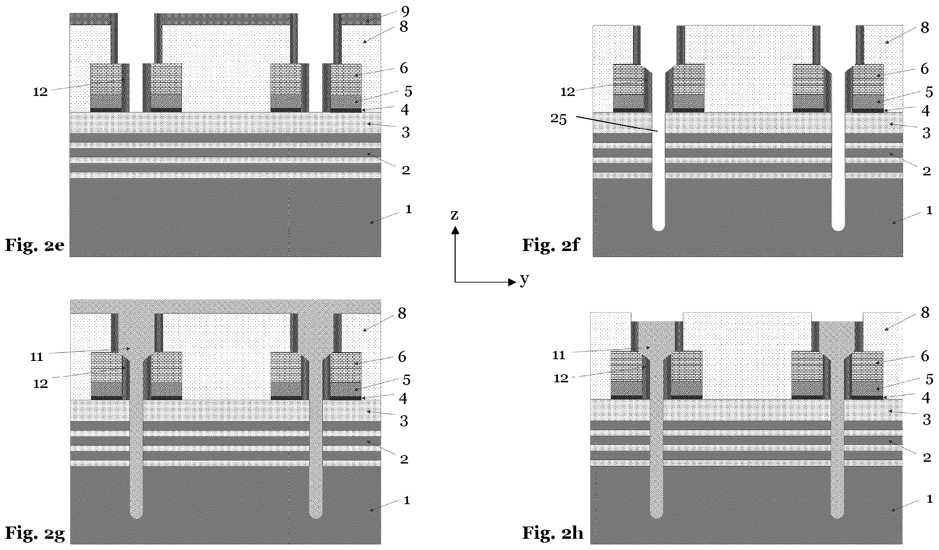

Figs. 2a-j shows steps of a method for processing a Forksheet device according to a further embodiment.

The method as shown in Figs. 2a-j differs from the method as shown in Figs. 1a-i mainly by the order of applying the spacer layer 7 and the sacrificial structure.

The method comprises, as shown in Fig. 2a, providing the substrate 21, which comprises the base structure 1, e.g. composed of Si, and the nanosheet structure of alternating nanolayers 2, 3 arranged on the base structure 1. The substrate 21 comprises the grating structure. In particular, the substrate 21 and the grating structure shown in Fig. 2a, is identical to the substrate 21 and the grating structure shown in Fig. 1a.

As shown in Fig. 2b, the method comprises forming the sacrificial structure directly on the substrate 21 and on and around the grating structure. The sacrificial structure can again comprises the three material layers 8, 9, 10, wherein the PR layer 10 can be opened in regions above the pair of maskings 23.

The sacrificial structure may further comprise an amorphous silicon (a-Si) layer. In particular, the a-Si layer can replace the SoC layer 8.

The method further comprises the selective removal of the sacrificial structure, in particular of the SoC and SoG layers 8, 9 in a region between the pair of maskings 23, as shown in Fig. 2c.

In a subsequent step, which is shown in Fig. 2d, the spacer layer 12 is formed on top of the remaining sacrificial structure as well as the pair of maskings 23 and the substrate in between the pair of maskings 23. In particular, the spacer layer 7 is also formed on facing sidewalls of the maskings 23.

The spacer layer 12 can be a SiO2 or a Si₃N₄ layer. In particular, the formation of the spacer layer 12 comprises a low temperature oxide formation.

As shown in Fig. 2e, the method further comprises selective removal of the spacer layer 12, e.g. by etching. In particular, the spacer layer 12 only remains intact at the facing sidewalls of the maskings 23 and/or facing sidewalls of the sacrificial structure on top of the maskings.

The remaining spacer layer 12 on the facing sidewalls of the maskings 23, can facilitate formation of the trench 25 between the maskings with critical dimensions, e.g. with a diameter smaller than the distance of the maskings 23. In other words, the remaining spacer layer 12 allows reducing the gap between the pair of the maskings 23 and, thus, the width of the trench 25 formed between the pair of maskings 23.

As shown in Figs. 2f-g, the method further comprises forming the trench 25 and filling said trench 25 with the filling material, preferably with the same processes as described above for Figs. 1e-f.

The method can further comprise, as shown in Fig. 2h, recessing the trench filling material 11. The filling material can be recessed by an isotropic dry etching process.

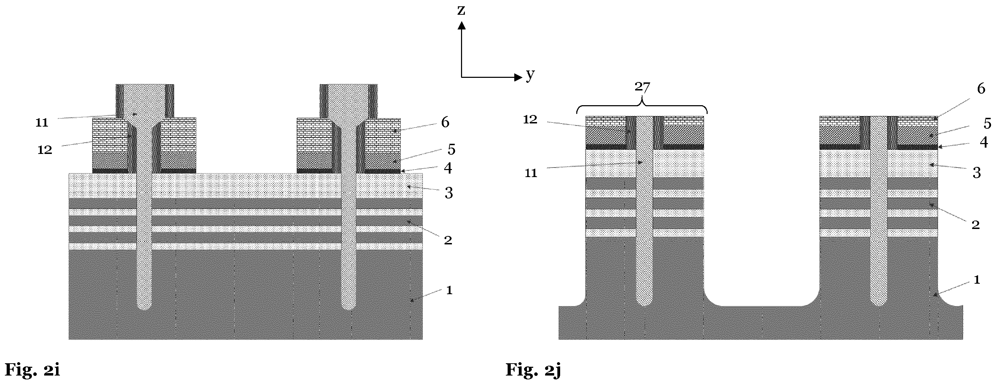

As shown in Figs. 2i-j, the method further comprises removing the remnants of the sacrificial structure and partially recessing the substrate 21 to form the fin structure 27, preferably with the same processes as described above for Figs. 1h-i.

Preferably, in a further step the method comprises forming the gate structure on and around the fin structure 27.

In the method, as shown in Figs. 2a-j, again the formation of the trench 25 is decoupled from the formation the fin structure 27. Thus, the depth of the trench can be controlled independently from the height of the fin structure 27. In particular, the trench 25 depth can be larger or essentially identical to the fin structure 27 height.

When using the same grating structure as a starting point, the method steps shown in Figs. 1a-i may result in different critical dimensions, in particular a different width, of the resulting fin structures 27 than the method steps shown in Figs 2a-j. The critical dimension of each fin structure 27 depends on the critical dimensions of the respective pair of maskings 23, in particular the width of each masking 23, their distance in y-direction, and on the spacer layer 7 on the side walls of the maskings 23, which increase the effective width of the maskings 23. In the method shown in Figs. 1a-i, the spacer layer 7 is arranged on facing and averted side walls of the maskings 23 (c.f. Fig. 1i), wherein in the method shown in Figs. 2a-j, the spacer layer 12 is only arranged on facing side walls of the maskings 23 (c.f. Fig. 2j). Thus, a fin structures 27 formed by the method shown in Figs. 1a-i has a width in y-direction which is increased by two times the thickness of the spacer layer 7 compared to the width of a fin structure formed by the method shown in Figs. 2a-j. The spacer layers 7, 12 on the facing sidewalls of the maskings 23 reduce the effective distance of the maskings and, thus, the diameter of the trench 25 in y-direction. Thus, forming the spacer layers 7, 12 prior to or following selective removal of the sacrificial structure provides a further critical dimension (CD) control of the trench 25 and/or the fin structure 27.

The fin structure 27 that formed with the method shown in Figs. 1a-i or in Figs. 2a-j can be a channel of the Forksheet (FSH) device. The method can comprise further steps, such as forming source and drain terminals that are connected by the fin structure or forming a connection to the gate structure.

The substrate 21 can be a wafer, in particular a Si wafer that comprises the nanosheet structure.

The scope of protection is solely defined by the amended set of claims.

## Claims

1. A method for processing a Forksheet device, wherein the method comprises:
- providing a substrate (21), wherein the substrate (21) comprises a nanosheet structure of alternating nanolayers (2, 3) of two different semiconductor materials;
- forming a trench (25) in the substrate (21), wherein the trench (25) extends along a first direction, wherein the trench (25) passes through the nanosheet structure;
- filling the trench (25) with a filling material (11);
- partially recessing the substrate (21) to form a fin structure (27), wherein the fin structure (27) comprises the filled trench (25), a first section of the substrate (21) at a first side of the filled trench (25) and a second section of the substrate (21) at a second side the filled trench (25), wherein the first and the second section of the substrate (21) form opposite sides of the fin structure (27) and each comprise a part of the nanosheet structure, and wherein the filled trench forms a dielectric isolation barrier of the fin structure (27);
- forming a p-doped region on or in the first section of the substrate (21) and forming an n-doped region on or in the second section of the substrate (21), wherein the p-doped and the n-doped regions are formed by means of an epitaxy growth process, during an epitaxial formation of source and drain terminals; and
- forming a gate structure on and around the fin structure (27);
wherein the step of forming the trench (25) in the substrate (21) comprises:
- forming a grating structure on the substrate, wherein the grating structure comprises a pair of maskings (23) extending along the first direction, wherein the pair of maskings (23) are arranged at a distance from each other; and
- etching into the substrate (21) in a region between the pair of maskings (23) to form the trench (25);
- wherein a spacer layer (7, 12) is formed at least partially around the pair of maskings (23), in particular on facing sidewalls of each of the pair of maskings (23).

2. The method according to claim 1, wherein the step of forming the trench (25) in the substrate (21) further comprises:
- forming, following the forming of the grating structure, a sacrificial structure on the substrate and on and around the grating structure, wherein the sacrificial structure comprises at least one material layer (8, 9, 10); and
- selectively removing the sacrificial structure in a region between the pair of maskings (23).

3. The method according to claim 1 or 2, wherein the spacer layer (7, 12) is formed prior to the forming of the sacrificial structure or following the selective removal of the sacrificial structure in the region between the pair of maskings (23).

4. The method according to any one of the preceding claims, wherein the fin structure (27) is formed by recessing, in particular etching, the substrate (21) at a distance from each side of the filled trench (25).

5. The method according to any one of claims 1 to 4, wherein the distance from each side of the filled trench (25) is defined by a width of the masking (23) on the respective side of the trench (25).

6. The method according to any one of the preceding claims, wherein a difference between a depth of the trench (25) and a height of the fin structure (27) is less than 10%, in particular less than 5%, more particular less than 2%, or wherein the depth of the trench (25) essentially corresponds to the height of the fin structure (27).

7. The method according to any one of the preceding claims, wherein the depth of the trench (25) is larger than or equal to the height of the fin structure (27).

8. The method according to any one of the preceding claims, wherein the filling material (11) comprises a dielectric material, in particular SiN, SiC, SiOCN, SiCN,SiO₂, SiCO, or SiON.

9. The method according to any one of the preceding claims, wherein the trench (25) is filled by means of a plasma-enhanced atomic layer deposition, PEALD, process.

## Patentansprüche

1. Verfahren zum Verarbeiten einer Forksheet-Vorrichtung, wobei das Verfahren umfasst:
- Bereitstellen eines Substrats (21), wobei das Substrat (21) eine Nanosheet-Struktur aus alternierenden Nanoschichten (2, 3) aus zwei verschiedenen Halbleitermaterialien umfasst;
- Bilden eines Grabens (25) in dem Substrat (21), wobei sich der Graben (25) entlang einer ersten Richtung erstreckt, wobei der Graben (25) durch die Nanosheet-Struktur verläuft;
- Füllen des Grabens (25) mit einem Füllmaterial (11);
- teilweises Vertiefen des Substrats (21), um eine Finnenstruktur (27) zu bilden, wobei die Finnenstruktur (27) den gefüllten Graben (25), einen ersten Abschnitt des Substrats (21) an einer ersten Seite des gefüllten Grabens (25) und einen zweiten Abschnitt des Substrats (21) an einer zweiten Seite des gefüllten Grabens (25) umfasst, wobei der erste und der zweite Abschnitt des Substrats (21) gegenüberliegende Seiten der Finnenstruktur (27) bilden und jeweils einen Teil der Nanosheet-Struktur umfassen, und wobei der gefüllte Graben eine dielektrische Isolationsbarriere der Finnenstruktur (27) bildet;
- Bilden einer p-dotierten Region auf oder in dem ersten Abschnitt des Substrats (21) und Bilden einer n-dotierten Region auf oder in dem zweiten Abschnitt des Substrats (21), wobei die p-dotierte und die n-dotierte Region mittels eines Epitaxiewachstumsprozesses während einer epitaktischen Bildung von Source- und Drain-Anschlüssen gebildet werden; und
- Bilden einer Gate-Struktur auf und um die Finnenstruktur (27);
wobei der Schritt des Bildens des Grabens (25) in dem Substrat (21) umfasst:
- Bilden einer Gitterstruktur auf dem Substrat, wobei die Gitterstruktur ein Paar von Maskierungen (23) umfasst, die sich entlang der ersten Richtung erstrecken, wobei das Paar von Maskierungen (23) in einem Abstand voneinander angeordnet ist; und
- Ätzen in das Substrat (21) in einer Region zwischen dem Paar von Maskierungen (23), um den Graben (25) zu bilden;
- wobei eine Spacer-Schicht (7, 12) zumindest teilweise um das Paar von Maskierungen (23) herum gebildet ist, insbesondere an zueinander weisenden Seitenwänden von jedem des Paars von Maskierungen (23).

2. Verfahren nach Anspruch 1, wobei der Schritt des Bildens des Grabens (25) in dem Substrat (21) ferner umfasst:
- Bilden einer Opferstruktur auf dem Substrat und auf und um die Gitterstruktur herum nach dem Bilden der Gitterstruktur, wobei die Opferstruktur mindestens eine Materialschicht (8, 9, 10) umfasst; und
- selektives Entfernen der Opferstruktur in einer Region zwischen dem Paar von Maskierungen (23).

3. Verfahren nach Anspruch 1 oder 2, wobei die Spacer-Schicht (7, 12) vor dem Bilden der Opferstruktur oder nach dem selektiven Entfernen der Opferstruktur in der Region zwischen dem Paar von Maskierungen (23) gebildet wird.

4. Verfahren nach einem der vorhergehenden Ansprüche, wobei die Finnenstruktur (27) durch Vertiefen, insbesondere Ätzen, des Substrats (21) in einem Abstand von jeder Seite des gefüllten Grabens (25) gebildet wird.

5. Verfahren nach einem der Ansprüche 1 bis 4, wobei der Abstand von jeder Seite des gefüllten Grabens (25) durch eine Breite der Maskierung (23) auf der jeweiligen Seite des Grabens (25) definiert ist.

6. Verfahren nach einem der vorhergehenden Ansprüche, wobei eine Differenz zwischen einer Tiefe des Grabens (25) und einer Höhe der Finnenstruktur (27) kleiner als 10 % ist, insbesondere kleiner als 5 %, spezieller kleiner als 2 %, oder wobei die Tiefe des Grabens (25) im Wesentlichen der Höhe der Finnenstruktur (27) entspricht.

7. Verfahren nach einem der vorhergehenden Ansprüche, wobei die Tiefe des Grabens (25) größer oder gleich der Höhe der Finnenstruktur (27) ist.

8. Verfahren nach einem der vorhergehenden Ansprüche, wobei das Füllmaterial (11) ein dielektrisches Material umfasst, insbesondere SiN, SiC, SiOCN, SiCN, SiO₂, SiCO oder SiON.

9. Verfahren nach einem der vorhergehenden Ansprüche, wobei der Graben (25) mittels eines PEALD-Prozesses (plasmaunterstützte Atomlagenabscheidung; Plasma-Enhanced Atomic Layer deposition) gefüllt wird.

## Revendications

1. Procédé destiné à traiter un dispositif Forksheet, le procédé comprenant :
- l'obtention d'un substrat (21), le substrat (21) comprenant une structure de nanofeuilles constituée de nanocouches alternées (2, 3) de deux matériaux semiconducteurs différents ;
- la formation d'une tranchée (25) dans le substrat (21), la tranchée (25) s'étendant le long d'une première direction, la tranchée (25) traversant la structure de nanofeuilles ;
- le remplissage de la tranchée (25) avec un matériau de remplissage (11) ;
- l'évidement partiel du substrat (21) pour former une structure d'aileron (27), la structure d'aileron (27) comprenant la tranchée remplie (25), une première section du substrat (21) sur un premier côté de la tranchée remplie (25) et une deuxième section du substrat (21) sur un deuxième côté de la tranchée remplie (25), la première et la deuxième section du substrat (21) formant des côtés opposés de la structure d'aileron (27) et comprenant chacune une partie de la structure de nanofeuilles, et la tranchée remplie formant une barrière d'isolation diélectrique de la structure d'aileron (27) ;
- la formation d'une région dopée p sur ou dans la première section du substrat (21) et la formation d'une région dopée n sur ou dans la deuxième section du substrat (21), les régions dopée p et dopée n étant formées au moyen d'un procédé de croissance par épitaxie, lors de la formation épitaxiale de bornes de source et de drain ; et
- la formation d'une structure de grille sur et autour de la structure d'aileron (27) ;
l'étape de formation de la tranchée (25) dans le substrat (21) comprenant :
- la formation d'une structure de réseau sur le substrat, la structure de réseau comprenant une paire de masques (23) s'étendant le long de la première direction, les masques de la paire de masques (23) étant disposés à distance l'un de l'autre ; et
- une gravure à l'intérieur du substrat (21) dans une région entre les masques de la paire de masques (23) pour former la tranchée (25) ;
- une couche d'entretoise (7, 12) étant formée au moins partiellement autour de la paire de masques (23), en particulier sur des parois latérales en vis-à-vis de chaque masque de la paire de masques (23).

2. Procédé selon la revendication 1, dans lequel l'étape de formation de la tranchée (25) dans le substrat (21) comprend en outre :
- la formation, après la formation de la structure de réseau, d'une structure sacrificielle sur le substrat et sur et autour de la structure de réseau, la structure sacrificielle comprenant au moins une couche de matériau (8, 9, 10) ; et
- le retrait sélectif de la structure sacrificielle dans une région entre les masques de la paire de masques (23).

3. Procédé selon la revendication 1 ou 2, dans lequel la couche d'entretoise (7, 12) est formée avant la formation de la structure sacrificielle ou après le retrait sélectif de la structure sacrificielle dans la région entre les masques de la paire de masques (23).

4. Procédé selon l'une quelconque des revendications précédentes, dans lequel la structure d'aileron (27) est formée par évidement, en particulier par gravure, du substrat (21) à distance de chaque côté de la tranchée remplie (25).

5. Procédé selon l'une quelconque des revendications 1 à 4, dans lequel la distance depuis chaque côté de la tranchée remplie (25) est définie par une largeur du masque (23) sur le côté respectif de la tranchée (25).

6. Procédé selon l'une quelconque des revendications précédentes, dans lequel une différence entre une profondeur de la tranchée (25) et une hauteur de la structure d'aileron (27) est inférieure à 10 %, en particulier inférieure à 5 %, plus particulièrement inférieure à 2 %, ou dans lequel la profondeur de la tranchée (25) correspond essentiellement à la hauteur de la structure d'aileron (27).

7. Procédé selon l'une quelconque des revendications précédentes, dans lequel la profondeur de la tranchée (25) est supérieure ou égale à la hauteur de la structure d'aileron (27).

8. Procédé selon l'une quelconque des revendications précédentes, dans lequel le matériau de remplissage (11) comprend un matériau diélectrique, en particulier SiN, SiC, SiOCN, SiCN, SiO₂, SiCO, ou SiON.

9. Procédé selon l'une quelconque des revendications précédentes, dans lequel la tranchée (25) est remplie au moyen d'un procédé de dépôt de couches atomiques assisté par plasma, PEALD.
